# EUROPEAN PATENT APPLICATION

(11) **EP 0 844 739 A1**
(43) Date of publication of application: **27.05.1998**
(21) Application number: 96830592.0
(22) Date of filing: 22.11.1996
(51) Int. Cl.: H03L 7/107

(54) **Phase-locked loop circuit, particularly for a transmitter-receiver system**

(71) Applicant: SGS-THOMSON MICROELECTRONICS s.r.l., 20041 Agrate Brianza (Milano) (IT)
(72) Inventor: Cosentino, Gaetano, 95123 Catania (IT)
(74) Representative: Cerbaro, Elena

(57) **Abstract**

The phase-locked loop circuit (40) includes a phase-frequency detector stage (41) having a first and a second gain value (K_{dH}, K_{dL}) enabled selectively; a first and a second loop filter (52, 50) having a first (H(s)_{H}) and, respectively, second (H(s)_{L}) transfer function enabled selectively, and each having a respective output (53, 51) connected to a controlled oscillator (60); a selection input (65) receiving a selection signal (SEL) having a first and a second level for selectively enabling the first gain value (K_{dH}) and the first filter element (52) in a first operating mode, and the second gain value (K_{dL}) and the second filter element (50) in a second operating mode, so that, in the first operating mode, the circuit has a high open-loop response gain and hence a wide band, and, in the second operating mode, the circuit has a narrow band and a higher damping factor for also ensuring stability in the second operating mode.

## Description

The present invention relates to a phase-locked loop circuit, particularly for a transmitter-receiver system.

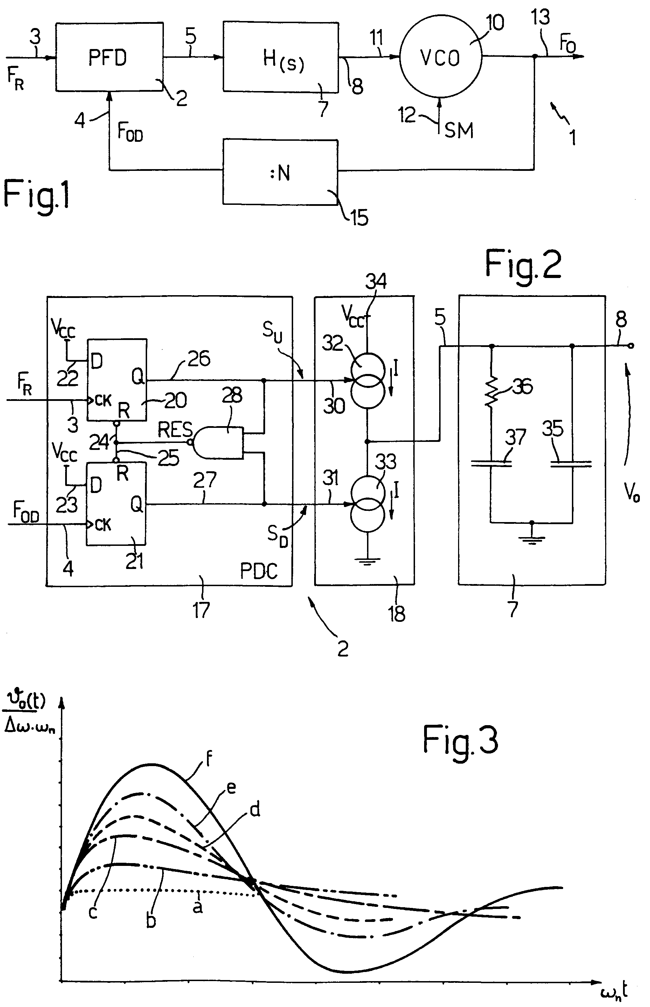

As is known, a classic phase-locked loop - hereinafter also referred to as PLL - comprises a phase-frequency detector stage, a loop filter, a frequency-controlled oscillator, and a divider connected between the output of the oscillator and an input of the phase-frequency detector stage. For a clearer understanding, Figure 1 shows a block diagram of a known PLL circuit indicated as a whole by 1, in which the phase-frequency detector stage (PFD) 2 has a first input 3 receiving a reference signal F_{R}, a second input 4 receiving a closed-loop signal F_{OD}, and an output 5; a loop filter 7, having a transfer function H(s), is cascade connected to detector stage 2 and has an output 8; and a voltage-controlled oscillator VCO 10 has a first input 11 connected to output 8 of loop filter 7, a second input 12 receiving a modulation signal SM, and an output 13 defining the output of circuit 1 and supplying a signal F_{O}. Output 13 of VCO 10 is also connected to the input of a frequency divider 15 connected to input 4 of detector stage 2 and supplying the signal F_{OD} resulting from frequency dividing output signal F_{O} by a predetermined value N (e.g. 1000).

An example embodiment of detector stage 2 and loop filter 7, in the case of a digital loop, is shown in Figure 2, in which detector stage 2 comprises two blocks 17 and 18 constituting the phase detector circuit itself and a gain circuit. More specifically, phase detector circuit (PDC) 17 comprises a first and second flip-flop 20, 21 having respective data inputs 22, 23 connected to a constant positive potential V_{CC} (logic "1"), respective clock inputs respectively defining input 3 and input 4 of detector stage 2, respective low-active reset inputs 24, 25, and respective Q outputs 26, 27. Outputs 26, 27 (respectively supplying signals S_{U}, S_{D}) are connected to respective inputs of a NAND gate 28 - the output of which is connected to reset inputs 24, 25 of flip-flops 20, 21 - and to respective control inputs 30, 31 of two controlled current sources 32, 33.

Current sources 32, 33 (also referred to globally as a charge pump) are stack connected to each other between supply line 34 at V_{CC} and ground, both supply a current I, the value of which determines the gain K_{d} of detector stage 2, and define a common node forming output 5 of stage 2. Filter 7, which is an impedance type, comprises the parallel connection of a first branch comprising a capacitor 35, and a second branch comprising the series connection of a resistor 36 and a capacitor 37; and the output voltage Vₒ of filter 7 represents the drive voltage of VCO 10. Alternatively, a differential solution (not shown) may be used featuring two pairs of current sources, wherein filter 7 is interposed between the sources in each pair (controlled by the output of the same flip-flop) so that current flows from one source in one pair to the other source in the same pair through filter 7 (the current direction in the filter being determined by the pair of sources enabled), and output voltage Vₒ is defined by the voltage drop at the terminals of filter 7.

In the Figure 2 circuit, flip-flops 20, 21 switch upon receiving the phase (switching edge) of respective signal F_{R} or F_{OD}; the switching edge of the first signal F_{R} or F_{OD} to arrive turns on the respective current source; and the second signal to arrive resets blocks 17, 18. For example, assuming the switching edge of signal F_{R} is the first to arrive, respective flip-flop 20 switches to switch signal S_{U} from 0 to 1 and turn on current source 32, which supplies current I to filter 7. When the phase (switching edge) of the other signal F_{OD} arrives, this switches flip-flop 21; signal S_{D} switches to 1 so that (besides source 33 being turned on briefly) reset signal RES is generated by NAND gate 28 to reset both flip-flops 20, 21, the Q outputs of which switch back to 0; reset signal RES also switches back to high (inactive); and flip-flops 20, 21 switch to standby awaiting the next switching edge.

Depending, therefore, on whether the switching edge of F_{R} or F_{OD} arrives first, source 32 or 33 is turned on to determine the sign of current I supplied to filter 7; and the delay between the two switching edges determines the power-on time of the source activated each time, and hence the value of the output voltage Vₒ of filter 7 controlling VCO 10. Negative-feedback closed-loop circuit 1 therefore provides in known manner for reducing the phase difference between reference signal F_{R} and loop signal F_{OD}.

The behaviour of the Figure 1 phase-locked loop circuit when a frequency step Δω is applied to reference signal F_{R} is shown in Figure 3, which shows various θ₀/(Δω ωₙ) versus ωₙt curves in the presence of various damping factors ξ (defined as the inverse of twice the quality factor Q; cf. Millman-Halkias, Integrated Electronics: Analog and Digital Circuits and Systems, McGraw-Hill, 1972, p. 453), and wherein θ₀ equals the phase variation caused by application of the step; ωₙ is the free-running frequency; and curve a corresponds to a value of ξ =5, curve b to ξ =2, curve c to ξ =1, curve d to ξ =0.707, curve e to ξ =0.5, and curve f to ξ =0.3. As can be seen, with high ξ values (corresponding, in open-loop analysis, to a high phase margin), the system shows a high degree of stability, whereas gradually decreasing ξ values are accompanied by a fall-off in system stability.

In PLL circuits, it is often necessary to change the closed-loop band, depending on how the system is operated. More specifically, in the case of circuits used in telecommunication transmitters/receivers, e.g. for DECT (Digital European Cordless Telecommunications) radio systems based on a time-sharing access technique in which various time slots are provided on a carrier for transmitting and receiving signals, the need to switch rapidly from one channel to another calls for a wide band. On the other hand, a narrow band is required when modulating the VCO (in the presence of signal SM) to ensure locking of the phase and prevent modulation impairing noise rejection.

To meet both requirements, two solutions have been proposed, as summarized for example in the article entitled "Isolator for DECT Open Loop Modulation" by R. Mohindra in INFO/CARD 24, p. 30-42, January 1996. In a first solution, during modulation, the loop is opened and the VCO output maintains the previously locked channel frequency. In other words, the loop is normally maintained closed to change the channel (variation of reference frequency F_{R}), and is opened just before transmitting or receiving a radiofrequency pulse train (signal SM). Such a solution involves several problems, due to the necessity of adequately compensating a possible jump in frequency caused by opening the loop, by dispersion currents of the loop filter capacitance, and by any current absorbed by the loop filter/oscillator interface (typically comprising the input of the oscillator itself).

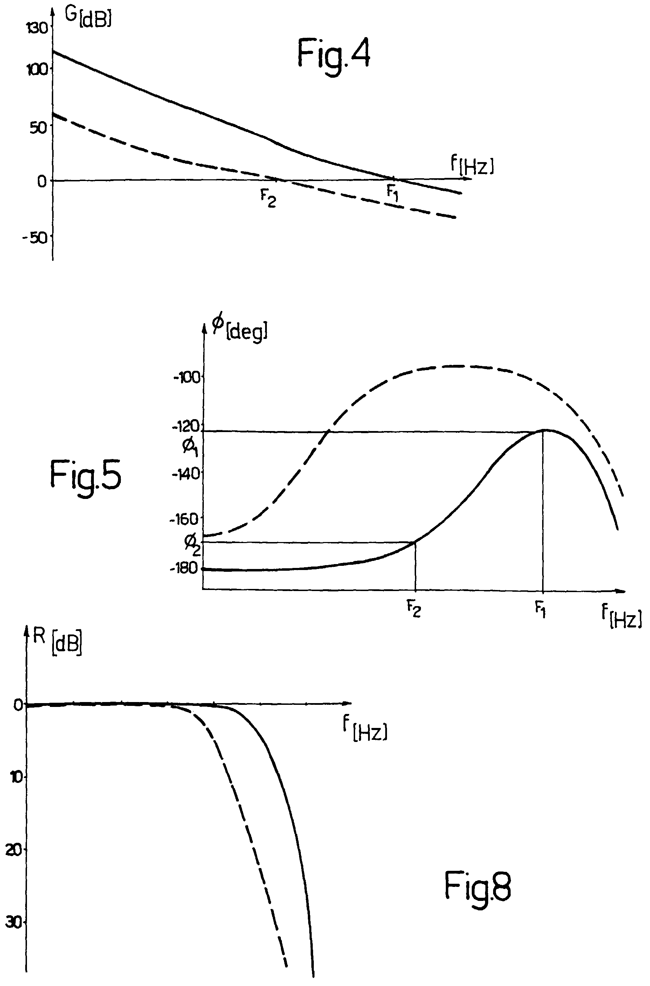

In a second solution, the circuit is closed-loop operated at all times, and bandwidth is modified by modifying the open-loop gain by simply reducing the module of the elements comprised between the reference signal input and the VCO. In the example described above, this may be achieved by reducing the gain K_{d} supplied by current sources 32, 33, i.e. their current level. The drawback of this solution, however, is that a reduction in gain alone is not enough to ensure an adequate damping factor so that, in certain situations, the system becomes unstable. In this connection, Figures 4 and 5 show Bode diagrams of gain G and phase Φ of the open-loop circuit transfer function. The continuous-life curve shows the gain and phase of the wide-band system. As can be seen, when the gain curve crosses the zero line (at frequency F1), the system presents a phase Φ1 of about -122° and therefore an acceptable phase margin (about 58° = 180° - 122°). Simply reducing gain K_{d}, as in the second solution, shifts the gain G curve, as shown for example by the dotted line, but not the phase curve Φ. In this case, the zero line is crossed at a lower frequency (F2), thus reducing the PLL pass band as required, but the corresponding phase Φ2 is much lower than before, thus reducing the phase margin and resulting in a high degree of instability of the system.

It is an object of the present invention to provide a phase-locked loop circuit, which provides for modifying the band according to operating conditions, and for overcoming the drawbacks typically associated with known solutions.

According to the present invention, there is provided a phase-locked loop circuit, in particular for a transmitter-receiver system, as claimed in Claim 1.

In practice, according to the present invention, the PLL circuit operates, in the absence of modulation, in such a manner that the open-loop response has a first gain value and the loop filter has a first transfer function with a first damping factor, and, during modulation, in such a manner that the open-loop response has a smaller second gain value and the loop filter has a second transfer function with a second damping factor greater than the first.

A number of preferred, non-limiting embodiments of the present invention will be described by way of example with reference to the accompanying drawings, in which:
Figure 1 shows a block diagram of a known phase-locked loop circuit;
Figure 2 shows a circuit diagram of some blocks of Figure 1;
Figure 3 shows the behaviour of the known circuit alongside variations in frequency;
Figures 4 and 5 show Bode diagrams;
Figure 6 shows a block diagram of a first embodiment of the loop circuit according to the invention;
Figure 7 shows a more detailed diagram of the Figure 6 circuit;
Figure 8 shows the closed-loop response of the Figure 7 circuit;
Figure 9 shows a block diagram of a second embodiment of the loop circuit according to the invention;
Figure 10 shows a circuit diagram of a third embodiment of the PLL circuit according to the invention.

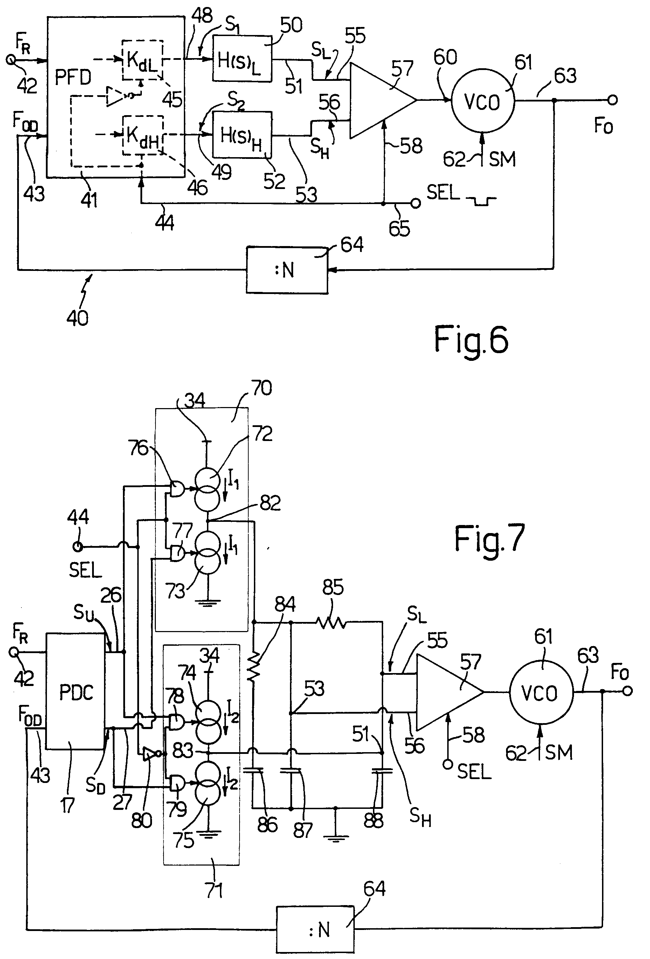

In Figure 6, the phase-locked loop (PLL) circuit, indicated as a whole by 40, comprises a phase-frequency detector stage 41 in turn comprising a first input 42 receiving reference signal F_{R}, a second input 43 receiving signal F_{OD}, and a third input 44 receiving a band selection signal SEL. Phase-frequency detector stage 41 has two different gain values K_{dL} and K_{dH} (as shown schematically by subblocks 45, 46) depending on whether PLL circuit 40 is narrow-band or wide-band operated, as determined by the state of signal SEL; and two outputs 48, 49 corresponding to the two different gain values, and generating respective signals S₁ and S₂. Output 48 is connected to the input of a first filter 50 having a first transfer function H(s)_{L} and an output 51 supplying a signal S_{L}; and output 49 is connected to the input of a second filter 52 having a second transfer function H(s)_{H} and an output 53 supplying a signal S_{H}.

Outputs 51, 53 are connected to respective data inputs 55, 56 of a buffer multiplexer 57, which also comprises a control input 58 receiving signal SEL so as to enable one or other of data inputs 55, 56. The output of buffer multiplexer 57 is connected to an input 60 of a VCO 61 having a second input 62 receiving signal SM; and, like the known circuit, the output 63 of VCO 61 constitutes the output of the circuit, and is connected to input 43 of phase-frequency detector stage 41 via a frequency divider 64.

Signal SEL has two levels (e.g. two different logic levels, in particular, two CMOS levels in the case of a digital signal), is supplied at an input 65 of PLL circuit 40, and is generated by a known external stage (not described in detail) for determining the narrow-band or wide-band operating mode of PLL circuit 40 (the SEL signal is similar, for example, to the ON and OFF synthesizer signal in the aforementioned article).

The Figure 6 circuit operates as follows. In the absence of signal SM, selection signal SEL at input 65 has a first level corresponding to wide-band operating mode. This first level causes the phase-frequency detector stage 41 to operate with high-gain, as represented in Figure 6 by enabling subblock 46 and disabling subblock 45. As such, output 49 supplies signal S₂ to filter 52, which in turn generates signal S_{H}, and signals S₁ and S_{L} are either absent or insignificant. The first level of signal SEL also enables input 56 and disables input 55 of buffer multiplexer 57, which therefore supplies wide-band signal S_{H} to input 60 of the VCO, so that PLL circuit 40 is wide-band operated to keep output signal F_{O} locked even in the event of a change in reference signal F_{R} (e.g. in the event of a change in the transmission/receiving channel).

Conversely, just before the VCO receives signal SM, selection signal SEL switches to the second level, which is used by phase-frequency detector stage 41 to switch from high-gain to low-gain operating mode, as represented in Figure 6 by enabling subblock 45 and disabling subblock 46. As such, output 48 supplies signal S₁ to filter 50, which in turn generates signal S_{L}, and signals S₂ and S_{H} are either absent or insignificant. The second level of signal SEL also enables input 55 and disables input 56 of buffer multiplexer 57, which therefore supplies narrow-band signal S_{L} to input 60 of the VCO, and PLL circuit 40 is narrow-band operated as required in this operating phase.

By virtue of phase-frequency detector stage 41 setting one of two different gain levels K_{dH}, K_{dL}, by providing for two selectively enabled loop filter elements with different transfer functions, and by appropriately sizing the components, the Bode diagram of the open-loop response of PLL circuit 40 shows two different curves as regards both gain and phase, as shown in Figures 4 and 5. More specifically, in the example shown, the open-loop transfer function of PLL circuit 40 presents the continuous-line curves in wide-band operating mode (like known circuits), and the dotted-line curves in narrow-band operating mode. As can be seen, the crossover frequency F2 of the narrow-band gain G curve corresponds to a small angle of the respective phase curve Φ, i.e. a high phase margin and therefore a high degree of stability of the system. The circuit therefore provides for a high degree of stability in any operating mode, with no delicate loop opening required.

An example embodiment of gain subblocks 45, 46 and loop filters 50, 52 for digital application is shown in Figure 7, in which the phase detector circuit is identical to PDC 17 in Figure 3, and is therefore indicated using the same reference number and not shown in detail. Outputs 26 and 27 of PDC 17 supply signals S_{U} and S_{D} to two charge pump circuits 70, 71 determining the two different gain values K_{dL} and K_{dH} of stage 41. More specifically, in the example shown, each charge pump circuit 70 and 71 comprises a first and second current source 72, 73 and 74, 75 stack connected between supply line 34 and ground. Current sources 72, 73 of first circuit 70 generate a first current I₁, and the current sources of second circuit 71 generate a second current I₂, where I₁>I₂; each source 72-75 has a control input connected to the output of a respective AND gate 76-79; AND gate 76 has a first input connected to output 26 of PDC 17, and a second input connected to selection input 44; AND gate 77 has a first input connected to output 27 of PDC 17, and a second input connected to selection input 44; AND gate 78 has a first input connected to output 26 of PDC 17, and a second input connected to selection input 44 via an inverter 80; and AND gate 79 has a first input connected to output 27 of PDC 17, and a second input connected to selection input 44 via inverter 80.

Current sources 72, 73 define an intermediate node 82; current sources 74, 75 define an intermediate node 83; node 82 is connected to first terminals of two resistors 84, 85, the respective second terminals of which are respectively grounded (via a capacitor 86) and connected to input 55 of buffer multiplexer 57; node 82 is also connected to input 56 of buffer multiplexer 57 and to a first terminal of a capacitor 87, the second terminal of which is grounded; and node 83 is connected to input 55 of buffer multiplexer 57 and to a first terminal of a capacitor 88, the second terminal of which is grounded.

In Figure 7, the capacitors are so sized that capacitance C1 of capacitor 86 is much higher (at least one order of magnitude) than capacitance C2 of capacitor 87, and capacitance C2 is much higher than capacitance C3 of capacitor 88, so that, in the operation band of PLL circuit 40, capacitors 87 and 88 may be disregarded by supplying high-frequency poles. Moreover, resistance R2 of resistor 85 is much higher than resistance R1 of resistor 84, so that, when charge pump circuit 70 and input 56 of buffer multiplexer 57 are enabled (wide-band mode), resistor 85 may be disregarded and, in practice, resistor 84 and capacitor 86 form filter 52, which, in high-gain (wide-band) mode, represents a filter with one pole and one zero; in this condition, intermediate node 82 defines both the input and output of filter 52 (both connected to input 56 of buffer multiplexer 57), and damping factor ξ is proportional only to resistance R1. Conversely, when charge pump circuit 71 and input 55 of buffer multiplexer 57 are enabled (narrow-band mode), resistor 85 is in series with resistor 84 and aids in forming filter 50; intermediate node 83 defines both the input and output of filter 50, both connected to input 55 of buffer multiplexer 57; and damping factor ξ is therefore proportional to R1+R2, thus increasing narrow-band stability.

In practice, the components forming filters 50 and 52 are not distinct and are so connected electrically as to give two different damping factors, depending on which charge pump circuit 70 or 71 and which input 55 or 56 are enabled.

PLL circuit 40 in Figure 7 operates as follows. The logic state (high or low) of signal SEL selectively enables charge pump circuit 70 or 71 via AND gates 76-79, and determines acquisition of the voltage at input 56 or 55 of buffer multiplexer 57, while the sequence in which the switching edges of signals F_{R} and F_{OD} are received determines the sign of current I₁ or I₂ supplied at node 82 or 83, as described with reference to Figure 2. In wide-band operating mode, therefore, the high current I₁ ensuring high gain is supplied or drawn; and the impedance filter formed by components 84 and 86 generates the corresponding voltage signal supplied to VCO 61. To switch PLL circuit 40 to narrow-band mode, the lower current I₂ is supplied or drawn to ensure a lower gain, and resistor 85 is connected in series with resistor 84 to modify the damping factor of the narrow-band loop and ensure adequate stability of the resulting PLL circuit 40.

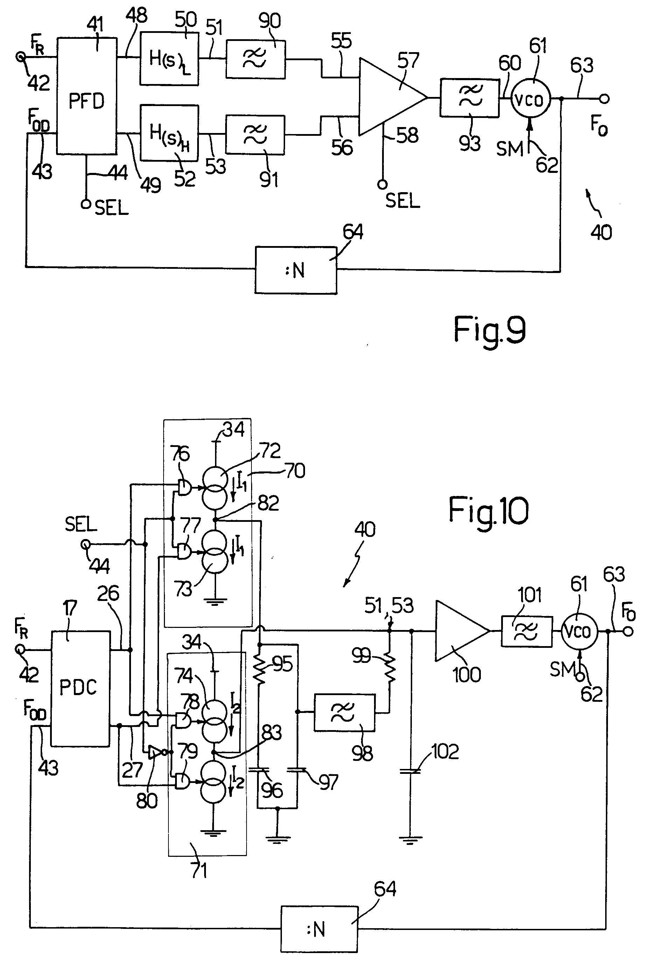

With the Figure 7 circuit, and by appropriately sizing the components, it is possible to achieve the closed-loop response curve shown in Figure 8, in which the continuous-line curve shows the wide-band response, and the dotted-line curve the narrow-band response. As can be seen, at low frequency, both curves show the same gain.

To ensure efficient operation of PLL circuit 40, components 84-88 must be so sized as to minimize the delay between the signal at input 56 and the signal at input 55 of buffer multiplexer 57 in wide-band mode, and so minimize the transient between wide-band and narrow-band mode when signal SEL switches from low to high.

Figure 9 shows a second embodiment, which differs from the first embodiment of Figure 6 by comprising auxiliary filter circuits. More specifically, in Figure 9, a low-pass filter 90 is provided between output 51 of narrow-band filter 50 and input 55 of buffer multiplexer 57; and a low-pass filter 91 is provided between output 53 of wide-band filter 52 and input 56 of buffer multiplexer 57. Low-pass filters 90, 91 are so sized as to have a cutoff frequency equal to at least 5 times the closed-loop band of wide-band PLL circuit 40, and provide for filtering noise components external to the PLL circuit band, and for better equalizing the signals at outputs 51 and 53 of loop filters 50, 52. A further low-pass filter 93 is provided between the output of buffer multiplexer 57 and input 60 of VCO 61, and, like filters 90, 91, is so sized as to filter undesired components external to the band of PLL circuit 40 and possibly generated by switching at the buffer multiplexer inputs. Filters 90, 91 and 93 must also be so sized as not to introduce significant phase delays within the band of PLL circuit 40. As for the rest, the Figure 9 PLL circuit operates in the same way as in Figure 6.

Figure 10 shows yet a further embodiment, in which buffer multiplexer 57 is replaced with a simple buffer. More specifically, in Figure 10, in which any elements in common with Figure 7 are indicated using the same reference numbers with no further description, node 82 of charge pump circuit 70 is connected to a first terminal of a resistor 95, the other terminal of which is grounded via a capacitor 96; a capacitor 97 is provided between node 82 and ground (parallel with the branch comprising components 95, 96); node 82 is connected to the input of an auxiliary low-pass filter 98, the output of which is connected via a resistor 99 to the input of a buffer element 100, the output of which is connected to a further auxiliary low-pass filter 101 interposed between buffer element 100 and input 60 of VCO 61; and a capacitor 102 is interposed between the input of buffer element 100 and ground.

In Figure 10, components 95, 96, 97, 99 and 102 are equivalent to components 84, 86, 87, 85 and 88 in Figure 7, and auxiliary low-pass filters 98 and 101 are equivalent to filter 90 or filters 91 and 93 in Figure 9. In wide-band mode, therefore, in which charge pump circuit 70 is enabled, resistor 99 may be disregarded by being much higher than resistor 95, components 95, 96 define a pole-zero filter representing transfer function H(s)_{H} (loop filter 52 with the input connected to intermediate node 82 and the output connected to the input of buffer element 100), and filters 98, 101 filter away noise components external to the pass band of PLL circuit 40. In narrow-band mode, resistor 99 is in series with resistor 95, and the current supplied or drawn by charge pump circuit 71 is filtered by an (R1+R2)-C1 impedance filter (input and output of loop filter 50 connected to the input of buffer element 100) with filters 98, 101 operating in the same way as described above. In this case, too, the components must be so sized that the cutoff frequency of the filter formed by components 99 and 102 and by filter 98 is higher (at least five times higher) than that of wide-band PLL circuit 40.

Clearly, changes may be made to the circuit as described and illustrated herein without, however, departing from the scope of the present invention. In particular, it should be emphasized that the principle described also applies to analog PLL circuits in which the phase detector and the gain stages are formed differently, e.g. by means of an analog multiplier and analog gain stages; the embodiment of the loop filters may differ from that described; the charge pump circuits may be so formed and connected to the filter elements as to supply a differential output voltage instead of an output voltage referred to ground as shown; and the auxiliary filters may be provided or not, e.g. the simple buffer solution in Figure 9 may be modified by eliminating auxiliary filters 98, 101. The circuit solutions shown are purely illustrative.

## Claims

1. A phase-locked loop circuit (40) comprising a phase-frequency detector stage (41); loop filter means (50, 52) cascade connected to said phase-frequency detector stage; a controlled oscillator (60) having an input (61) connected to an output of said loop filter; a feedback branch (64) interposed between an output (63) of said controlled oscillator and an input (43) of said phase-frequency detector stage; and bandwidth modifying means (65, SEL); characterized in that said phase-frequency detector stage (41) has a first and a second gain value (K_{dH}, K_{dL}) enabled selectively; in that said loop filter means comprise a first and a second filter element (52, 50) having a first (H(s)_{H}) and, respectively, second (H(s)_{L}) transfer function enabled selectively, and each having a respective output (53, 51) connected to said controlled oscillator (60); and in that said bandwidth modifying means comprise selection means (65, SEL) for selectively enabling said first gain value (K_{dH}) and said first filter element (52) in a first operating mode, and said second gain value (K_{dL}) and said second filter element (50) in a second operating mode.

2. A circuit as claimed in Claim 1, characterized in that said selection means comprise a selection input (65) receiving a first selection signal (SEL) having a first and a second level for selectively enabling said first and said second gain value (K_{dH}, K_{dL}).

3. A circuit as claimed in Claim 2, characterized in that said detector stage (41) comprises a first gain circuit (46, 70) having said first gain value (K_{dH}), and a second gain circuit (45, 71) having said second gain value (K_{dL}); said first and said second gain circuit each having a respective enabling input receiving said first selection signal (SEL) and, respectively, a second selection signal inverted with respect to said first selection signal, and a respective output (49, 48) connected to a respective input of said first and, respectively, said second filter element (52, 50).

4. A circuit as claimed in Claim 2 or 3, characterized by switching means (57) having a first and a second signal input (56, 55), a control input (58), and an output; said first signal input (56) being connected to said output (53) of said first filter element (52); said second signal input (55) being connected to said output (51) of said second filter element (50); said control input (58) being connected to said selection input (65) and selectively enabling said first and said second signal input on the basis of said first and said second selection level; and said output of said switching means (57) being connected to said controlled oscillator (60).

5. A circuit as claimed in Claim 4, characterized in that said switching means comprise a buffer multiplexer (65).

6. A circuit as claimed in Claim 4 or 5, characterized by comprising a first and a second low-pass filter (91, 90) interposed respectively between said first filter element (52) and said first signal input (56), and between said second filter element (50) and said second signal input (55); and a third low-pass filter (93) interposed between said output of said switching means (57) and said controlled oscillator (60).

7. A circuit as claimed in Claim 2 or 3, characterized by buffer means (100) having an input connected to said outputs (53, 51) of said first and second filter elements (52, 50).

8. A circuit as claimed in any one of the foregoing Claims from 3 to 7, characterized in that said detector stage (41) is digital, and comprises a digital phase detector circuit (17); said phase detector circuit having a first and a second input (42, 43) respectively receiving a reference signal (F_{R}) and a loop signal (F_{OD}), and determining a phase difference between said reference and loop signals, said phase difference having a sign; said phase detector circuit (17) also having a first and a second output (26, 27) selectively supplying a first and a second phase difference signal (S_{U}, S_{D}) on the basis of said sign of said phase difference; said first and said second gain circuit (70, 71) each also having a first and a second signal input connected respectively to said first and said second output (26, 27) of said phase detector circuit (17); said enabling input of said first gain circuit (70) being connected to said selection input (65); said enabling input of said second gain circuit (71) being connected to said selection input via an inverting element (80); said output (82) of said first gain circuit being connected to said input of said first filter element (52); and said output (83) of said second gain circuit being connected to said input of said second filter element (50).

9. A circuit as claimed in Claim 8, characterized in that said first and said second gain circuit (70, 71) each comprise a charge pump circuit.

10. A circuit as claimed in any one of the foregoing Claims 3-6, 8 and 9, characterized in that said loop filter means (52, 50) comprise an RC network (84, 86) connected between said output (82) of said first gain circuit (70) and a reference potential line; and a first resistive element (85) connected between said output of said first gain circuit and said output (51) of said second filter element (50); said output (83) of said second gain circuit (71) being connected to said output (51) of said second filter element (50); said RC network (84, 86) defining said first filter element (52); said RC network and said first resistive element (85) defining said second filter element (50); said output (82) of said first gain circuit defining said input and said output (53) of said first filter element (52); and said output (83) of said second gain circuit (71) defining said input and said output (51) of said second filter element (50).

11. A circuit as claimed in Claim 7, characterized in that said loop filter means (52, 50) comprises an RC network (95, 96) connected between said output (82) of said first gain circuit (70) and a reference potential line; and a first resistive element (99) connected between said output of said first gain circuit and said input of said buffer means (100); said output (83) of said second gain circuit (71) being connected to said input of said buffer means (100); said RC network (95, 96) defining said first filter element (52); said RC network and said first resistive element (99) defining said second filter element (50); said output (82) of said first gain circuit (70) defining said input of said first filter element (52); and said input of said buffer means (100) defining said output (53) of said first filter element (52), and said input and said output (51) of said second filter element (50).

12. A circuit as claimed in Claim 11, characterized by a fourth low-pass filter (98) interposed between said output (82) of said first gain circuit (70) and said first resistive element (99); and a fifth filter (101) interposed between an output of said buffer element (100) and said controlled oscillator (60).

13. A circuit as claimed in any one of the foregoing Claims from 10 to 12, characterized in that said loop filter means (52, 50) also comprise a first capacitive element (87; 97) interposed between said output (82) of said first gain circuit (70) and said reference potential line; and a second capacitive element (88; 102) interposed between said output (83) of said second gain circuit (71) and said reference potential line.

14. A circuit as claimed in Claim 13, characterized in that said RC network comprises a second resistive element (84; 95) and a third capacitive element (86; 96) in series with each other; said second resistive element 84; 95) having a resistance (R1) much lower than said first resistive element (85; 99); said third capacitive element (86; 96) having a capacitance (C1) much higher than said first capacitive element (87; 97); and said first capacitive element having a capacitance (C2) much higher than said second capacitive element (88; 102).
